# EUROPEAN PATENT APPLICATION

(11) **EP 0 615 282 A2**
(43) Date of publication of application: **14.09.1994**
(21) Application number: 94103605.5
(22) Date of filing: 09.03.1994
(51) Int. Cl.: H01L 21/336, H01L 21/76, H01L 29/784

(54) **Methods for making MOSFET's with drain separated from channel**

(30) Priority: 10.03.1993 KR 9303575
(71) Applicant: SAMSUNG ELECTRONICS CO., LTD., Suwon-city, Kyungki-do 441-373 (KR)
(72) Inventor: Jeonguk, Han, Paldal-ku, Suwon, Kyungki-do (KR)
(74) Representative: KUHNEN, WACKER & PARTNER

(57) **Abstract**

A method for making a gooved-gate metal oxide semiconductor field effect transistor (MOSFET) with its drain separated from channel regions (DSC structure) is proposed for the purpose of meeting all the requirements of device reliability and performance that are introduced in the deep submicron technique.

According to the present invention, channel regions and field areas are defined simultaneously and a MOSFET with concave-shaped channel regions separated from a drain region is formed by using LOCOS, such that surface damage produced by etching the silicon substrate may be prevented. The impurity for controlling a threshold voltage is implanted all over the channel regions to prevent reduction of the mobility of carrier and transconductance that may be generated in the region where the channel regions are separated from the drain region.

## Description

### BACKGROUND OF THE INVENTION

### (1) Field of the Invention

The present invention relates to a method for making a metal oxide semiconductor field effect transistor. More particularly, it relates to a method for making a metal oxide semiconductor field effect transistor having a recessed gate structure that may reduce short-channel effects without trench- etching and/or etching processes.

### (2) Description of the Prior Art

For past years, manufacturing techniques of metal oxide semiconductor field effect transistors (MOSFETs) have been rapidly developed, reducing the minimum size of structural elements of integrated circuits by the ratio of about 10%. This trend is expected to continue in 1990's. Thus, the size of a MOSFET (gate length Lg orchannel length) has been reduced to a deep submicron region (Lg<0.35um) from a submicron region (Lg<1I.Lm) for the increase of device performance and integrity. However, as the size of a MOSFET is reduced to the submicron region, it is difficult to suit best short-channel effects, hot carrier effects, and device characteristics altogether, according to the reduction of electric field.

According to the scaling law, the speed of device performance has been improved but problems of device reliability are caused. The limit to the size of voltages placed is resulted not from short-channel effects such as simple punchthrough voltages but from the reduction of device reliability by the increase of energy carrier (or increase of temperatures, E = 3/2kT) due to the increase of electric fields inside the channel.

From the late in the 1980's, the study on MOSFETs has been focused on the limit of device by scaling and the scaling limit by device reliability. Besides, there has been studied a structure that may moderate the scaling limit, by enhancing the device reliability. According to KITE REVIEW, Vol. 19 No. 5 pp 402 - 413, the device cannot be totally turned off at gate voltages Vg = OV by short-channel effects.

In such a technological background, there is a structure in which channel regions are not formed on the same plane as that of source/drain regions in order to overcome the limit of short-channel effects. EIJI TAKEDA et al referred to such a structure "MOSFET with Drain Separated from Channel Implanted Region (DSC)" in IEEE Ttans. Electron Devices, Vol. 30, No. 6, 1983.

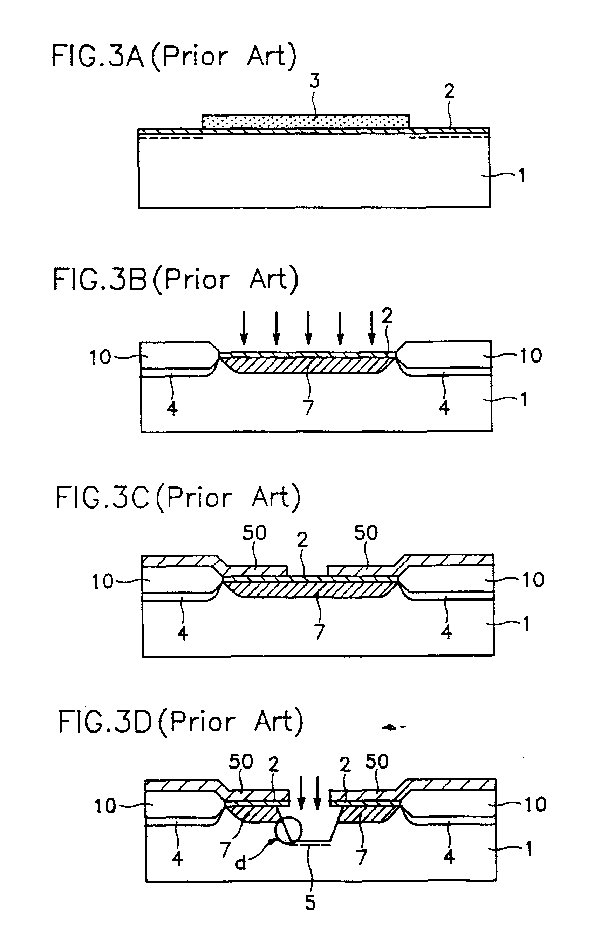

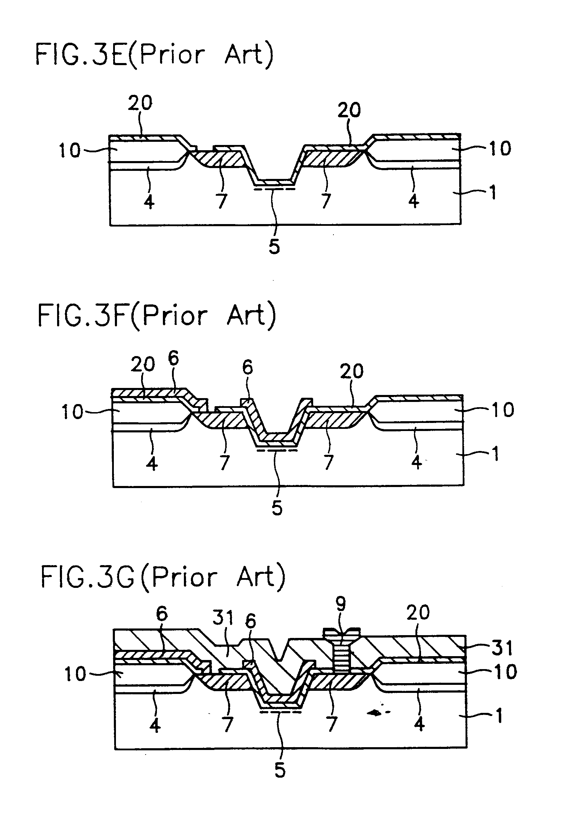

FIGS. 3A to 3G show the steps in the manufacture of MOSFET with DSC.

First, a pad oxide layer 2 and a nitride layer 3 are formed on a first conductivity type silicon substrate 1. The nitride layer 3 is patterned to define an active region and a first conductivity type impurity is ion-implanted to define an impurity region for channel stopper (FIG. 3A).

After that, a local oxidation of silicon (LOCOS) process is performed to form a field oxide layer 10, and the nitride layer 3 is then removed. A source/drain region 7 is formed by ion-implanting second conductivity type impurity with high dosage, as shown in FIG. 3B.

Referring now to FIG. 3C, the silicon substrate 1 is etched to form a groove by using a photoresist film 50 and the pad oxide layer 2 as a mask. And, a first conductivity type impurity is ion-implanted to form a structure in which a channel region 5 is formed below the source/drain region 7, as shown in FIG. 3D.

As shown in FIGS. 3E to 3G, after the photoresist film 50 and pad oxide layer 2 are removed, and gate oxide layers 20 are formed, a contact hole is formed in the source/drain regions 7 by means of the mask. Polysilicon layers 6 are deposited, and an interlayer insulating layer 31 is formed. The drain region 7 is provided with a conductive layer 9 and used as a wiring electrode to obtain a complete DSC-MOSFET, as shown in FIG. 3G.

The DSC-MOSFET made through the above- mentioned processes, has remarkably excellent characteristics in short-channel effects by deeply trenching the channel region 5 compared to the source/drain regions 7 to dispose source/drain junctions on the higher position than that of the gate. However, the DSC-MOSFET made in a prior art technology has a technical difficulty of dry-etching the silicon substrate and a problem of deterioration to device performance characteristics caused by the reduction of transconductance because of damage of the substrate surface.

Besides, since the impurity is not fully implanted to a region "d", a separated region between the channel region 5 and source/drain regions 7, the mobility of carrier is reduced, which deteriorates current driving capability at last.

### SUMMARY OF THE INVENTION

The present invention seeks to solve the above problems.

It is an object of this invention to provide a method for making a metal oxide semiconductor field effect transistor that can meet all the requirements of reliability and performance as well, by solving a difficulty of dry-etching a substrate and forming channel regions to be separated from source/drain regions.

The present invention provides a method for making a metal oxide semiconductor field effect transistor, comprising the steps of:
forming a buffer layer and an anti-oxidation layer on a silicon substrate to define simultaneously channel and field areas;
forming field oxide layers through an oxidation process;
removing the buffer layer, anti-oxidation layer and field oxide layer to form a concave-shaped channel region;
forming a gate insulating layer and a gate material layer and patterning the gate material layer; and
forming source/drain regions and a region of field oxide layer.

According to another aspect of the present invention, a method for making a metal oxide semiconductor field effect transistor, comprises the steps of:
forming a first buffer layer and a first anti-oxidation layer on a silicon substrate to define simultaneously channel and field areas;
forming first field oxide layers through a first oxidation process;
removing the first buffer layer, first anti-oxidation layer and first field oxide layer to form a concave-shaped channel region;
forming a second buffer and a second anti-oxidation layer, and removing the second anti-oxidation layer in the field region;
forming second field oxide layers through a second oxidation process;
forming a gate insulating layer and a gate material layer, and patterning the gate material layer; and
forming source/drain regions.

### BRIEF DESCRIPTION OF THE DRAWINGS

FIGS. 1A to 1H depict the steps in the manufacture of a metal oxide semiconductor field effect transistor in accordance with a first preferred embodiment of this invention;
FIGS. 2A to 2F depict the steps in the manufacture of a metal oxide semiconductor field effect transistor in accordance with a second preferred embodiment of this invention; and
FIGS. 3A to 3G depict the steps in the manufacture of a metal oxide semiconductor field effect transistor in a conventional way.

### DETAILED DESCRIPTION OF THE PREFERRED

### EMBODIMENTS

Preferred embodiments of the present invention are now fully described with reference to the attached drawings.

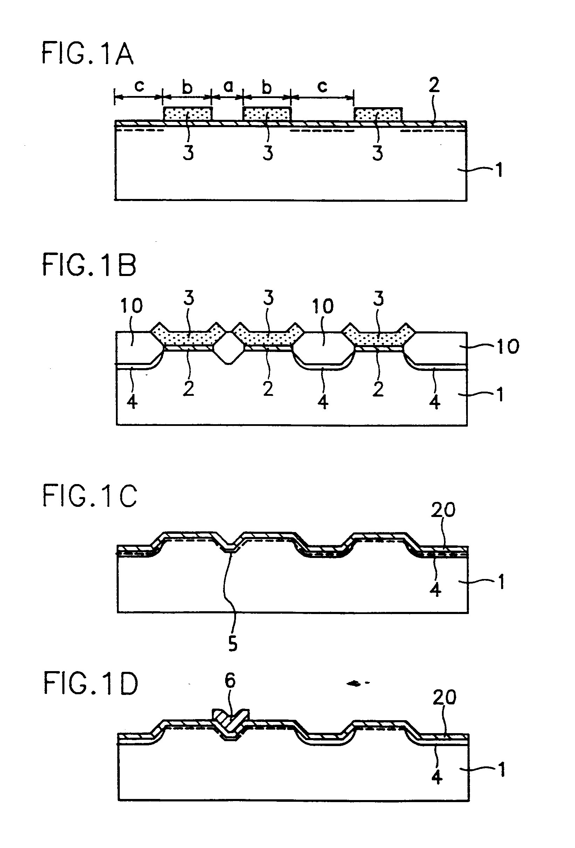

FIGS. 1A to 1H are the steps in the manufacture of a metal oxide semiconductor field effect transistor with a channel separated from source/drain regions in accordance with the preferred embodiments of this invention.

Referring now to FIG. 1A, a first step is to define simultaneously a channel area a and field areas c. First, a pad oxide layer 2, buffer layer, and nitride layers 3, anti-oxidation layer are formed on a semiconductor substrate 1 of a predetermined conductivity type. The channel area a and field areas c are simultaneously defined and a high dose impurity of the same conductivity type as that of the substrate 1 is ion-implanted.

At this point, source/drain regions will be formed in an area "b". A second step is to form impurity regions 4 for channel stopper and field oxide layers 10 by performing a local oxidation of silicon (LOCOS) process on the channel area and the field areas defined through the first step (FIG. 1 B).

A third step is to form a channel region 5. After the pad oxide layers 2, nitride layers 3 and field oxide layers 10 are completely removed, a gate oxide layer 20 is formed all over the substrate, and a high dose impurity of the same conductivity type as that of the substrate is ion-implanted to control a threshold voltage. A channel region 5 of concave shape (M) is formed, as shown in FIG. 1 C.

The above process of the present invention does not include an additional process for defining the conventional channel regions (FIGS. 3A to 3G) and surface damage caused by dry-etching the substrate. Moreover, the impurity for controlling a threshold voltage is ion-implanted all over the substrate in the present invention, and there is no reduction of the mobility of carrier and transconductance generated in the separated region (the region "d" in FIG. 3D) between the channel and source/drain regions.

A fourth step is to form a polysilicon gate 6 over the channel region 5 of concave shape (M) ( FIG. 1 D).

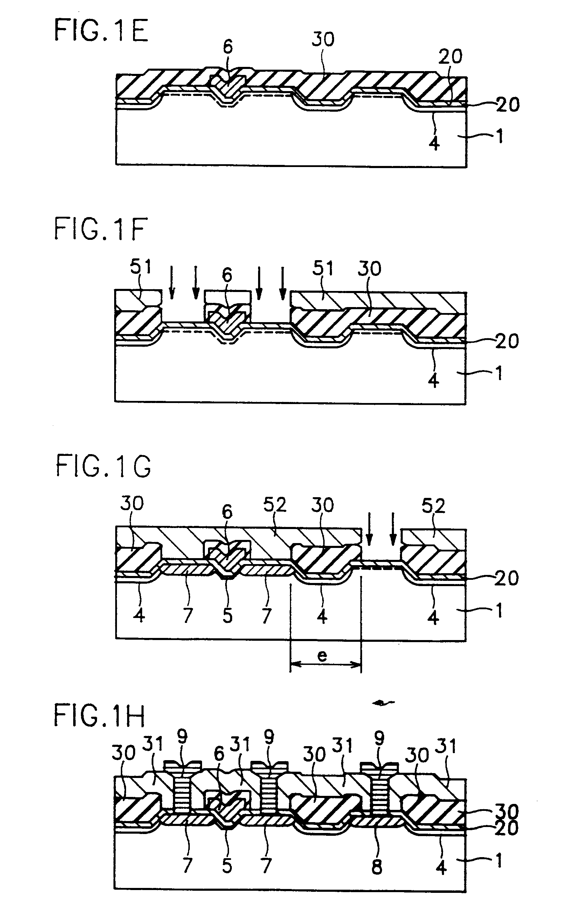

A fifth step is to form a chemical vapor deposition (CVD) oxide layer 30 to insulate the polysilicon gate layer 6 from a metal layer that is formed through the post process. In the present invention, a photoresist film (not illustrated) is deposited for planarization of device, and an etch-back process is then performed to form the CVD oxide layer 30 having good step coverage, as shown in FIG. 1 E.

This process may be deleted, if necessary.

A sixth step is to form the source/drain regions 7 and a high dose impurity region 8 having the same conductivity type as that of the substrate 1, referring to FIGS. 1 and 1 G. The source/drain regions 7 are formed by implanting a high dose impurity of the different conductivity type from that of the substrate 1, after the CVD oxide layer 30 is etched by using a pattern of a photoresist film 51 as a mask. The above impurity region 8 is formed by using the pattern of the photoresist film 52, and the implanted impurity has the same conductivity as that of the substrate 1. A region of a field oxide layer indicated by letter "e" is defined simultaneously with the etch-back process and the formation of source/drain and impurity regions 7 and 8, and may be regulated and controlled in size.

The narrow field region e may isolate electrical elements from each other. Finally, interlayer insulating layers 31 are opened and conductive layers 9 are provided by burying a metal on a contact hole such that a MOSFET with a drain separated from the channel region (DSC) is completely formed as shown in FIG. 1 H.

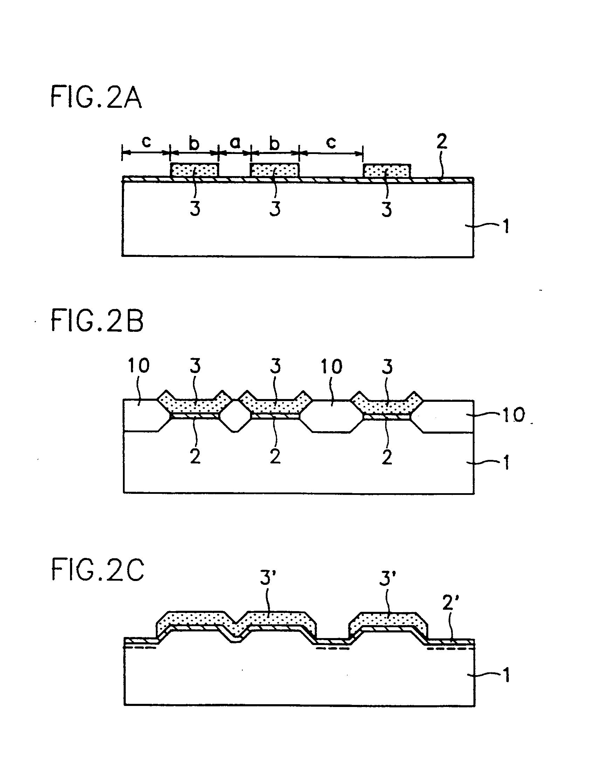

A second embodiment of a method for making a MOSFET with a drain separated from a channel region is now described with reference to FIGS. 2A to 2F that correspond to each of FIGS. 1A to 1H, and the same description will be deleted. This second embodiment may reduce remarkably a bird's beak configuration of the field oxide layer compared to that of the first preferred embodiment and maintain the initial planarization of device.

Like the first preferred embodiment, first nitride layers 3 are patterned on a first pad oxide layer 2 to define an active area a and field areas c (FIG. 2A). First field oxide layers 10 are formed by performing a local oxidation (LOCOS) without ion- implantation (FIG. 2B).

Subsequently, after the first pad oxide layers 2, nitride layers 3 and field oxide layers 10 are removed, second nitride layers 3' are formed on an active region over the second pad oxide layer 2', and impurity for channel stopper is ion-implanted to form a structure of FIG. 2C.

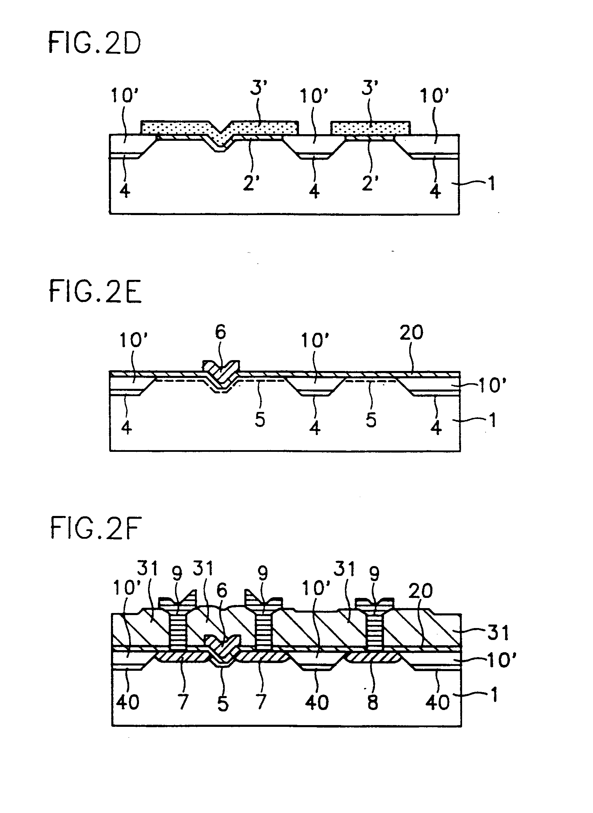

A second LOCOS process is carried out on the field regions defined through the above process to form impurity regions for channel stopper 4 having the same conductivity type as that of the substrate 1 and second field oxide layers 10' without the bird's beak configuration (FIG. 2D).

Referring now to FIG. 2E, a gate oxide layer 20 is formed after removal of the second nitride layers 3' and pad oxide layers 2'. Impurity of the same conductivity type as that of the substrate is ion-implanted all over the substrate 1 for controlling a threshold voltage.

The sixth step of the first preferred embodiment and wiring process are carried out on the above structure to form a MOSFET with source/drain regions 7 separated from the concave-shaped channel regions 5, as shown in FIG. 2F.

As described above, according to the present invention, channel regions and field areas are defined simultaneously and a MOSFET with concave-shaped channel regions separated from a drain region is formed by using LOCOS, such that surface damage produced by etching the silicon substrate may be prevented. The impurity for controlling a threshold voltage is implanted all over the channel regions to prevent reduction of the mobility of carrier and transconductance that may be generated in the region where the channel regions are separated from the drain region.

Besides, the present invention facilitates planarization of device and controls the size of each region. Accordingly, the present invention may enhance the reliability and performance of device, a basic object of MOSFET according to the scale-down.

## Claims

1. A method for making a metal oxide semiconductor field effect transistor, comprising the steps of:
forming a buffer layer and an anti-oxidation layer on a silicon substrate to define simultaneously channel and field areas;
forming field oxide layers through an oxidation process;
removing said buffer layer, anti-oxidation layer and field oxide layer to form a concave-shaped channel region;
forming a gate insulating layer and a gate material layer and patterning said gate material layer; and
forming source/drain regions and a region of field oxide layer.

2. A method according to claim 1, wherein said step for forming said region of field oxide layer further includes an etch-back process for planarization of a device.

3. A method for making a metal oxide semiconductor field effect transistor, comprising the steps of:
forming a first buffer layer and a first anti-oxidation layer on a silicon substrate to define simultaneously channel and field areas;
forming first field oxide layers through a first oxidation process;
removing said first buffer layer, first anti-oxidation layer and first field oxide layer to form a concave-shaped channel region;
forming a second buffer and a second anti-oxidation layer, and removing the second anti-oxidation layer in the field region;
forming second field oxide layers through a second oxidation process;
forming a gate insulating layer and a gate material layer, and patterning said gate material layer; and
forming source/drain regions.
